# EUROPEAN PATENT APPLICATION

(11) **EP 3 136 527 A1**
(43) Date of publication of application: **01.03.2017**
(21) Application number: 15182930.6
(22) Date of filing: 28.08.2015
(51) Int. Cl.: H02H 3/24, G01R 19/165

(54) **PROCEDURE AND DEVICE FOR ADAPTIVE AND CONTINUOUS DETECTION OF VOLTAGE DROP IN THE ELECTRICAL WIRING SYSTEM**

(71) Applicant: Müller, Michael, 4962 Clemency (LU)
(72) Inventor: Müller, Michael, 4962 Clemency (LU)

(57) **Abstract**

Procedure and device (Fig. 3) for adaptive and continuous detection of voltage drop in the electrical wiring system of buildings and of national/local electrical networks that continuously detects, in an adaptive way, the voltage drop and warns the user about this failure and/or disconnects the faulty circuit. It contains a new method of current voltage drop detection by using an adaptive reference that follows the variation of steady-state voltage instead of fixed upper and lower safe limits, used by current methods.

The steady-state voltage is continuously recorded and used as reference. This reference is compared to the voltage at outlet output after the electrical device has been plugged in and during its usage. If the difference of voltage is outside of the range of values established by the norms for voltage drop, a warning is generated and/or the faulty circuit is disconnected.

## Description

### BACKGROUND OF THE INVENTION

### Field of the invention

An important voltage drop in electrical wiring circuit occurs when current passes through a hazardous, out of limits and high resistance faulty wires or connections. The greater the resistance of the circuit, the higher the voltage drop and the heating at a high resistance connection/splice may result in a fire.

### Purpose of the invention

The purpose of the invention is the creation of a procedure and of a device that continuously detects, in adaptive way, the voltage drop in electrical circuits of buildings and of national/local networks and warns users about this failure with option to disconnect the faulty circuit.

### Description of Prior Art

### a) Voltage limits

The steady-state voltage (line voltage) is the voltage a customer can expect to receive under normal operating conditions. Since the loads on a utility system are constantly changing, it is impossible to maintain a completely constant voltage.

In EU, the nominal voltage is 230 Volts with an accepted variation of +/- 10%, with a maximum of 250 Volts and a minimum of 210 Volts.

The US Companies are providing voltage regulation to keep the steady-state voltage within the ranges as indicated by ANSI standard C84.1. This standard shows voltage limits in % deviation from nominal, for circuits with no lighting equipment, range A applies to normal operations and range B applies for short duration and/or abnormal conditions on the utility system (excluding fault conditions and transients).

Important: Jurisdictional Public Service Commissions may specify other voltage limits.

### b) Responsibility and consequences

It is the responsibility of the customer to design their electrical system to ensure the utilization voltage guidelines from EU standards and ANSI standard C84.1 for US and it is the customer's responsibility to protect sensitive equipment from these voltage swells by using fast acting voltage regulators or power conditioners.

Despite all devices currently used for protection, the problem of electrical fires involving electrical failure or malfunction hasn't been solved, neither in Europe, neither in US while U.S. fire departments responded 2007-2011 to an estimated annual average of 47,820 reported home structure electrical ignition of fires. These fires resulted in 455 civilian deaths, 1,518 civilian injuries and $1.5 billion in direct property damage.

Electrical failure or malfunction was cited as factor contributing to ignition for 74% of electrical distribution or lighting equipment home structure fires. Source: NFPA's "Electrical Fires," by John R. Hall, Jr., April 2013. The largest portion of fires caused by electrical distribution systems (48%) were caused by faulty fixed wiring, receptacles and switches. None of electric protections proposed for buildings by EU and US regulatory including Ground Fault Circuit Interrupter and the more recent device: AFCIs, provides a specific protection against "glowing" connections and wires. "Glowing" occurs when electric current crosses an unexpected high resistance of the electric circuit. Heat comes from power dissipation. This energy, when dissipated in a small junction area, can generate temperatures above 1000 °C (1832 °F) and can ignite most flammable materials.

### In conclusion:

1) the problem of continuous detection of "glowing" parts of electrical circuit inside of buildings isn't solved and that's the cause of the highest number of today building fires,
2) the presence of the "glowing" segments of electrical wiring system can be detected by the voltage drop on that circuit.

### c) The voltage drop

In France, NFC 15-100 states that a voltage drop can't exceed 3-5%, depending on the consumer type (7-11 Volts).

In Germany, DIN VDE 0100-520 norms provide a maximum voltage drop at 3%. (7 Volts)

In US, the National Electrical Code (NEC 210-19 FPN No. 4) states that a voltage drop of 5% at the furthest receptacle in a branch wiring circuit is acceptable for normal efficiency.

In a 230 Volt, 15 Ampere circuit should be no more than 7 Volts voltage drop. In US, in a 120 volt 15 ampere circuit, this means that there should be no more than a 6 volt drop (114 volts) at the furthest outlet when the circuit is fully loaded. It also means that the circuit has a resistance that does not exceed 0.46 ohms for EU and 0.4 in US.

The cause of the voltage drop is usually (from: http://www.psihq.com/iread/faqvolt.htm, Frequently Asked Questions - Voltage Drop, by Harold P. Kopp):
1. High resistance connections at wiring junctions or outlet terminals, usually caused by:
   a) poor splices anywhere in the circuit,
   b) loose or intermittent connections anywhere in the circuit,
   c) corroded connections anywhere in the circuit,
   d) inadequate seating of wire in the slot connection on back wired "push-in type" receptacles and switches.
2. The wire does not meet code standards (not heavy enough gauge for the length of the run).

Most of these faulty circuits and receptacles could have been identified as hazards with the proposed device for voltage drop detection, and the major part of these fires could have been easily prevented.

### d) Current devices for voltage drop detection

1) The Philadelphia Housing Development Corp requires contractors to perform the voltage drop-under-load test prior to installing blown insulation in existing homes. If the voltage drop is 10 % or higher (they found that 70% of the older homes failed the NEC's 5% criteria), the contractor must replace/repair the circuit. These tests are welcomed and necessary but can't be continuously performed and because wiring connections deteriorate in time (particularly in homes that use aluminum wiring for power circuits), and do-it-yourself modifications may be less than professional, a house which recently passed these tests can have serious electrical problems.
   These tests also don't take into account all the possible types of consumers (as in different currents and impedances).
2) Out-of-Parameter Circuit Interrupters (OPCI) are designed to protect against top electrical fire ignition. The current proposed Power Fault Circuit Interrupters (PFCI) and Voltage Out-of-Parameter Circuit Interrupters (OPCI) analyze the line voltage, compare it against both upper and lower safe limits, and disconnect the load when they detect hazardous conditions, but this approach detects only very severe cases of voltage drop failures, and not all dangerousness cases.

### For example, in EU:

An electrical power supply company provides 240 Volts. The minimum voltage accepted by EU norms is 210 Volts. By considering the normed voltage drop of 7 Volts, the lower safe limit to be measured by PFCI at outlet output is set at 203 Volts.

In the presented case, the measured voltage at outlet is 205 Volts, so, this case isn't detected as a possible failure by the Out-of Parameters devices.

While the company provides 240 Volts, the real voltage drop in that circuit is 240 - 205 = 35 Volts, largely above the 7 Volts, maximum value accepted by EU norms.

Even though the OPCIs do not detect the problem, the power dissipation, even for a medium usage of that outlet (I = 5 A) is 175W, is more than sufficient to initiate a fire.

### For example, in US:

An electrical power supply company provides 125 Volts. The minimum voltage accepted by ANSI C84.1 -Range A, is 114 Volts. By considering the acceptable voltage drop of 6 Volts, the lower safe limit is set at 108 Volts.

In the circuit, the measured voltage is 109 Volts, so, this case isn't detected as a possible failure by the Out-of Parameters devices.

While the company provides 125 Volts, the real voltage drop in that circuit is 125 - 109 =16 Volts, largely above the 6 Volts, maximum value accepted by NEC

The power dissipation, even for a medium usage of that outlet (I = 5 A) is 80W, is sufficient to start a fire.

### In conclusion:

- the detection of the voltage drop in the electrical wire system of a building (7 Volts for EU and 6 for US) has to be performed by considering the variation of steady-state voltage. If not, this variation (+/- 20Volts in EU and +/6 Volts in US) will impact the measurement of voltage drop inside of the building and will end-up with non-reliable results. The above presented examples prove the non-detection by current OPCI and PFCI devices of dangerousness cases, with a major electrical power dissipation that can ignite most of flammable materials.
- It's the responsibility of the customer to design and maintain their electrical system to ensure the utilization voltage guidelines from EU standards and ANSI standard but there are no reliable devices available today to help them to do so.
- the voltage drop-under-load tests, performed once in a while, help to detect wiring system failures but only a verification performed continuously can ensure the timely detection of failures.

### SUMMARY OF THE INVENTION

The invention device belongs to OPCI and PFCI classes of devices.

The proposed invention contains a new method of current voltage drop detection by using an adaptive reference. It significantly outperforms the previous art which compares it against upper and lower safe limits, methods which, as shown above, are not reliable because of significant variation of steady-state voltage.

### DETAIL DESCRIPTION OF THE INVENTION

The steady-state voltage is continuously captured and recorded by the invented device and used as reference. The adaptive reference will store the last snapshot of this voltage, just before an electrical device is plugged in. This reference is compared to the voltage at outlet output after the electrical device has been plugged in. If the difference of voltage is outside of the range of values indicated by the norms for voltage drop, then a warning is generated and the faulty circuit is, optionally, disconnected.

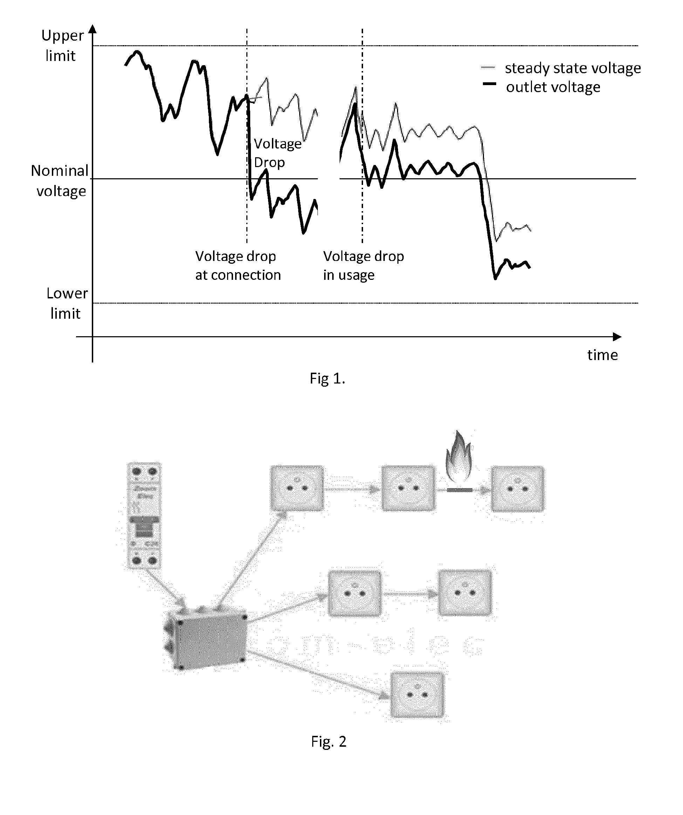

The detection of voltage drop is active during the usage of the electrical devices too, by detecting the voltage drops that happen anytime during the current usage of electrical devices. (Fig. 1)

The detection works continuously, independently of the electrical power consumed by the electrical consumer. This invention detects the problem independently of the current passing through the network. If a voltage drop is detected as being outside of norms during a low power usage (e.g.: I = 2 Ampers), then a high usage of that circuit (e.g. I=10 Ampers) will surely end-up into a major failure and probably, in fire.

### For example:

The invented device detects a voltage drop outside the norms (7 Volts).

If the resistance of faulty circuit is: R =7 Volts/2 Amperes = 3.5 Ohms, the power dissipation is P = 7 Volts x 2 Ampers = 14 Watts. This energy will heat the faulty segment of the circuit but the risk of fire is low.

If the same outlet will be used next time for a high power device (I=10 Amperes) it will dissipate on the faulty circuit: P = R² x I = 122.5 Watts, energy that will highly probable generate a fire.

This solution is powerful because it detects the danger also in safe circumstances.

The invented device includes a bi-stable circuit that is triggered by the voltage drop detector; the duration of a voltage drop is detected even if its duration is less than 0.2 seconds.

The purpose of this invention being the detection of voltage drops in the wiring system of the buildings and not the analysis of the quality of the steady-state voltage, the invented device filters the non-dangerous transients (transients are deviations from the AC sine wave having a very short duration, typically from a fraction of a microsecond to a very few milliseconds). The invented device is located in receptacles while only from the receptacle a PFCI can detect the voltage drop (Fig. 2).

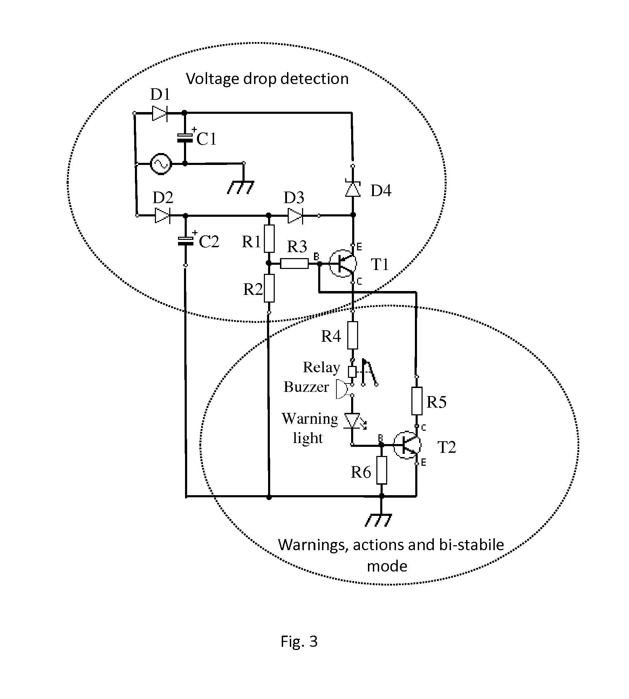

Its electronic schema is presented in (Fig 3).

The capacitors C1 and C2 are charged at U nominal √2 via diodes D1, D2. When a device is plugged into the outlet, the U nominal decreases with the value of voltage drop at U nominal - U voltage drop. The capacitor C2 discharges rapidly via the resistances R1 and R2 and C1 slowly discharges over time. The voltage difference represents the voltage drop, value that is compared with the fixed voltage of Zener diode D4. If the voltage drop value is higher than the voltage of Zener diode, then the transistor T1, used in switch mode, will be saturated and the warning light (LED), the Buzzer and/or the Relay are powered. The transistor T2 works with T1 in bi-stabile mode, via R3, R4, R5 and R6.

### THE ADVANTAGES OF THE INVENTION

The invented method and device propose an adaptive and continuous detection of voltage drops in the electrical wiring system of buildings. Its usage will detect and prevent:
a) electrical failures and malfunctions cited as factor contributing to ignition for 74% of electrical distribution or lighting equipment building structure fires.
b) an excessive electric power dissipation, lost on wiring system of the buildings

An electrical building system containing this device can be tested at how it behaves at maximum capacity anytime by its users by plugging in a consumer using 15 Ampers.

## Claims

1. Procedure for adaptive and continuous detection of voltage drop in electrical circuits comprising:
- an adaptive reference voltage that follows the fluctuation of steady-state voltage,
- a continuous verification of voltage drop as difference between the reference voltage and instant voltage
- an action component triggered by the detection of a voltage drop value outside of a predefined range,
- warning signals and/or disconnections.

2. A power voltage drop detecting procedure according to claim 1 wherein the detection of voltage drop is performed for wiring systems of buildings and for the national/local electric networks.

3. A power voltage drop detecting procedure according to claim 1 wherein the detection of voltage drop is performed for alternative voltage, including the circuits connected to national electric network.

4. A power voltage drop detecting procedure according to claim 1 wherein the detection of voltage drop is performed in DC after the conversion AC-DC.

5. A power voltage drop detecting procedure according to claim 1 wherein the fluctuant reference is stored in a capacitor.

6. A power voltage drop detecting procedure according to claim 1 wherein the voltage drop is computed in an analog way, as difference between the voltages of two capacitors.

7. A power voltage drop detecting procedure according to claim 6 wherein the voltage drop is verified to be in the ranges established by norms by being compared with the voltage of one Zener diode or equivalent, where its breakdown voltage is correlated with the maximum value accepted for voltage drop.

8. A power voltage drop detecting procedure according to claim 1 where the capacitors are loaded by a DC voltage converted from AC via one diode.

9. Device for adaptive and continuously detection of voltage drop in the AC electrical circuits where the voltage drop is computed in an analog way, as difference between the voltages of two capacitors, loaded in DC via diodes, one capacitor being loaded by the reference voltage that follows the variation of steady-state voltage and the second capacitor being loaded by instant voltage, this difference being compared via a Zener diode or equivalent with the maximum value accepted for voltage drop.

10. Device for adaptive and continuously detection of voltage drop according to claim 9 where a bi-stable electronic circuit built from transistors is triggered by the detection of a voltage drop.

11. Device for adaptive and continuously detection of voltage drop according to claim 9 built according to the electrical scheme presented in the (fig. 3) or equivalent.
